# DEMANDE DE BREVET EUROPEEN

(11) **EP 4 485 547 A1**
(43) Date de publication de la demande: **01.01.2025**
(21) Numéro de dépôt: 24182928.2
(22) Date de dépôt: 18.06.2024
(51) Int. Cl.: H01L 29/792, H01L 21/28, G11C 16/04, H01L 29/423, H10B 43/30

(54) **DISPOSITIF DE MÉMOIRE NON-VOLATILE ET PROCÉDÉ DE FABRICATION CORRESPONDANT**

(30) Priorité: 30.06.2023 FR 2306973
(71) Demandeur: STMicroelectronics International N.V., 1228 Plan-les-Ouates, Geneva (CH)
(72) Inventeur: HABHAB, Radouane, 13003 Marseille (FR); DELLA MARCA, Vincenzo, 13004 Marseille (FR); MIRIDI, Nadia, 13390 Auriol (FR); MASSON, Pascal, 06560 Valbonne (FR); MELUL, Franck, 13400 Aubagne (FR); AKBAL, Madjid, 13530 Trets (FR)
(74) Mandataire: Casalonga

(57) **Abrégé**

Le dispositif de mémoire non-volatile comporte des cellules mémoires (CEL1, CEL2) comportant une grille de commande (CG) verticalement enterrée dans un substrat semiconducteur (SUB) dopée d'un premier type de dopants, et une interface diélectrique (ITFD) apte à piéger des charges électriques recouvrant des flancs (FL1, FL2) de la grille de commande (CG) en regard du substrat semiconducteur. Le dispositif comporte en outre une région implantée verticale (AdVt) d'un deuxième type de dopants opposé au premier type située le long desdits flancs de la grille de commande (FL1, FL2) dans le substrat semiconducteur (SUB).

## Description

Des modes de réalisation et de mise en oeuvre concernent les circuits intégrés, en particulier les circuits intégrés comportant un dispositif de mémoire non-volatile telle qu'une mémoire dite à piégeage de charges.

Les mémoires non-volatiles classiques sont typiquement basées sur l'usage de transistors comportant une région conductrice de grille flottante, pour stocker une charge électrique de manière non-volatile afin de coder une donnée mémorisée.

Dans les mémoires à piégeage de charge, les charges électriques sont stockées dans des « pièges de charges » d'une interface diélectrique. Par exemple, l'interface diélectrique de piégeage de charge peut comporter une couche de nitrure de silicium pouvant être encadrée (« en sandwich ») de part et d'autre par des couches d'oxyde de silicium, auquel cas on peut parler de technologie du type « SONOS » (pour « Silicium Oxyde Nitrure Oxyde Silicium »). D'autres technologies de piégeage de charges existent, telle que les diélectriques riches en silicium (usuellement « Si-Rich » en anglais), ou les technologies dites à « nanocristaux » de silicium.

Typiquement, les mémoires à piégeage de charge conventionnelles comportent une structure de transistor planaire classique dans lequel la couche de diélectrique de grilles est composée de l'interface diélectrique de piégeage de charges. En conséquence, les technologies de mémoire à piégeage de charge conventionnelles ne présentent pas un grand avantage sur le plan de l'empreinte surfacique (ou « footprint » en anglais, ou bien la « taille » en français) par rapport à une technologie de transistor à grille flottante.

D'autre part, les mémoires à piégeage de charge conventionnelles peuvent permettre des programmations (arbitrairement, une écriture d'un « 0 » ou resp. d'un « 1 ») avec une granularité d'un bit, mais imposent typiquement des effacements (arbitrairement, une écriture d'un « 1 » ou resp. d'un « 0 ») avec une granularité plus grande, par exemple une granularité d'une page, c'est-à-dire la taille matériellement définie d'une rangée de cellules-mémoires.

En effet, les opérations d'effacement classiques sont mises en oeuvre par effet Fowler-Nordheim commandé par une haute-tension entre la grille de commande et le substrat semiconducteur, usuellement avec un potentiel négatif dans la grille de commande et un potentiel positif ou nul dans le substrat. En conséquence, les potentiels d'effacement classiques ne sont sélectifs que sur le groupe de cellules mémoires qui partagent la même grille de commande (typiquement une rangée).

Ainsi, il existe un besoin de bénéficier de mémoires à piégeage de charge plus compactes, avec une granularité avantageuse pour les deux opérations d'écritures en programmation et en effacement, par exemple une granularité d'un bit, tout en limitant le nombre d'étapes de fabrications afin de réduire les coûts de production.

Selon un aspect, il est proposé à ces égards un dispositif, par exemple réalisé de façon intégrée dans un circuit intégré, de mémoire non-volatile comportant des cellules-mémoires comportant une grille de commande verticalement enterrée dans un substrat semiconducteur dopé d'un premier type de dopants, par exemple le type P, et une interface diélectrique apte à piéger des charges électriques recouvrant des flancs de la grille de commande en regard du substrat semiconducteur. Chaque cellule-mémoire comporte en outre une région implantée verticale d'un deuxième type de dopants opposé au premier type, par exemple le type N, située le long desdits flancs de la grille de commande dans le substrat semiconducteur.

D'une part, la disposition verticale et enterrée dans le substrat de la structure de la grille de commande et de l'interface diélectrique, permet de grandement réduire la surface du substrat occupée par chaque cellule mémoire.

D'autre part, la région implantée verticale dans le substrat semiconducteur le long desdits flancs de la grille de commande, étant dopée du type opposé au type du substrat, permet de fournir source de porteurs de charge minoritaires dans le substrat, sans créer un canal d'inversion dans le substrat. En conséquence, on peut bénéficier pour l'effacement de la même sélectivité que pour la programmation, avantageusement obtenue grâce à la formation d'un canal d'inversion, tandis que l'effacement n'engendre pas de canal d'inversion.

Selon un mode de réalisation, chaque cellule mémoires comporte une première région de conduction dopée du deuxième type de dopants, située dans le substrat au niveau d'une surface supérieure et d'un côté de la grille de commande, et une deuxième région de conduction dopée du deuxième type de dopants, située dans le substrat en profondeur au niveau du fond d'une tranchée contenant la grille de commande.

La première région de conduction, par exemple la région de drain, permet notamment d'accéder sélectivement à la cellule-mémoire individuellement via une piste usuellement nommé ligne de bits (ou « bit line » en anglais) ; tandis que la deuxième région de conduction, par exemple la région de source, est avantageusement mutualisés pour les cellules mémoires appartenant à un même groupe, par exemple une rangée, voire tout ou une portion d'un plan-mémoire.

En outre, on notera que la première région de conduction est située d'un seul côté de la grille de commande, de sorte qu'une même structure de gille de commande peut être commune à deux cellules-mémoires (chacune ayant sa région de drain d'un côté respectif de la grille de commande), usuellement distinguées par les termes « paires » et « impaires ». Ceci est là-encore avantageux en matière d'empreinte surfacique.

Selon un mode de réalisation, le dispositif comporte en outre des moyens d'écriture configurés pour générer des conditions d'effacement adaptées à une injection de porteurs chauds de charge d'un premier signe, par exemple le signe positif, dans l'interface diélectrique, depuis ladite région implantée verticale comme source de porteurs de charge du premier signe.

Ainsi, dans le cas où le premier type de dopants (c'est-à-dire le type du substrat) est le type P, et que les régions implantées verticales située le long desdits flancs de la grille de commande sont de type N, cela correspond à des conditions d'effacement mettant en oeuvre une injection porteurs chauds de charge positive, c'est-à-dire une injection de « trous » chauds (le premier signe étant le signe positif). Et, contrairement à un effacement par extraction global des charges piégées par effet Fowler-Nordheim mis en oeuvre entre la grille de commande et le substrat ; l'effacement par injection de trous chauds correspond à une recombinaison d'une charge négative (électrons) contenue dans un piège avec une charge positive (trous) injectée dans le même piège et provenant de ladite source de porteurs de charge positives. Ainsi, l'effacement par injection de trous chauds n'est pas global et peut être sélectif par cellule-mémoires individuelles.

Selon un mode de réalisation, les moyens d'écriture sont configurés pour générer les conditions d'effacement comprenant une polarisation de la grille de commande à un potentiel d'un deuxième signe, par exemple le signe négatif, et une polarisation de la région implantée verticale à un potentiel du premier signe, par exemple le signe positif.

Cela correspond à un exemple de conditions pour l'effacement par injection de trous chauds, sélectives pour chaque cellule-mémoires, mentionnés ci-avant.

Selon un mode de réalisation, les moyens d'écriture sont configurés pour générer la polarisation de la région implantée verticale avec un potentiel du premier signe non-nul dans la première région de conduction et un potentiel de référence nul dans la deuxième région de conduction, ou avec un potentiel de premier signe non-nul dans la deuxième région de conduction et un potentiel de référence nul dans la première région de conduction.

En effet, selon l'orientation de la tension entre les régions de conductions, par exemple de la source vers le drain (ou respectivement du drain vers la source), le champ électrique sera le plus grand au niveau de la jonction PN entre le drain et le substrat (ou respectivement au niveau de la jonction PN entre la source et le substrat).

Or, les ionisations par impacts, c'est-à-dire les générations de porteurs chauds, vont se produire là où le champ électrique est le plus grand, c'est-à-dire au niveau de l'une ou l'autre desdites jonctions PN.

Ainsi, on peut prévoir deux régions distinctes d'ionisation par impact dans une même cellule mémoire, et donc deux localités de l'interface diélectrique pour piéger des charges par injection de porteurs chauds. Cela permet avantageusement de pouvoir stocker indépendamment deux bits par cellule-mémoire.

En outre, lorsque la même structure de gille de commande est commune à deux cellules-mémoires, une seule structure de grille de commande permet ainsi d'accéder à quatre bits, chacun de ces quatre bits étant accessible sélectivement et individuellement en effacement, en programmation, ainsi qu'en lecture.

Selon un mode de réalisation, les moyens d'écriture sont en outre configurés pour générer des conditions de programmation adaptées à une injection de porteurs chauds de charge du deuxième signe, par exemple le signe négatif, dans l'interface diélectrique, depuis une région de canal formée le long desdits flancs de la grille de commande dans le substrat semiconducteur comme source de porteur de charge du deuxième signe.

Selon un mode de réalisation, les moyens d'écriture sont en outre configurés pour générer les conditions de programmation comprenant une polarisation de la grille de commande à un potentiel du premier signe.

Selon un mode de réalisation, la région implantée verticale est dopée avec une concentration en dopants du deuxième type comprise entre 5*10¹⁵ at/cm³ et 10¹⁸ at/cm³, le substrat semiconducteur étant dopé avec une concentration en dopants du premier type inférieure à 5*10¹⁵ at/cm³.

Et par exemple, la première région de conduction peut être dopée avec une concentration en dopants du deuxième type comprise entre 10¹⁸ at/cm³ et 10²⁰ at/cm³ ; la deuxième région de conduction peut être dopée avec une concentration en dopants du deuxième type comprise entre 5*10¹⁵ at/cm³ et 10¹⁸ at/cm³.

Selon un mode de réalisation, ladite grille de commande enterrée appartient à une tranchée s'étendant verticalement dans le substrat et est superposée à une grille de sélection dans ladite tranchée.

Selon un autre aspect, il est également proposé un procédé de fabrication d'un dispositif de mémoire non-volatile comportant des cellules mémoires, la fabrication de chaque cellule mémoire comprenant :
- une formation d'une grille de commande verticalement enterrée dans un substrat semiconducteur dopée d'un premier type de dopants ;
- une formation d'une interface diélectrique apte à piéger des charges électriques recouvrant des flancs de la grille de commande en regard du substrat semiconducteur ; et en outre
- une formation d'une région implantée verticale d'un deuxième type de dopants opposé au premier type située le long desdits flancs de la grille de commande dans le substrat semiconducteur.

Selon un mode de mise en oeuvre, ladite fabrication de chaque cellule mémoires comprend :
- une formation d'une première région de conduction dopée du deuxième type de dopants, située dans le substrat au niveau d'une surface supérieure et d'un côté de la grille de commande, et
- une formation d'une deuxième région de conduction dopée du deuxième type de dopants, située dans le substrat en profondeur au niveau du fond d'une tranchée contenant la grille de commande.

Selon un mode de mise en oeuvre, comportant en outre des opérations d'écriture comprenant une génération de conditions d'effacement produisant une injection de porteurs chauds de charge d'un premier signe, par exemple le signe positif, dans l'interface diélectrique, depuis ladite région implantée verticale comme source de porteurs de charge du premier signe.

Selon un mode de mise en oeuvre, les opérations d'écriture comprennent une génération des conditions d'effacement comprenant une polarisation de la grille de commande à un potentiel d'un deuxième signe, par exemple le signe négatif, et une polarisation de la région implantée verticale à un potentiel du premier signe.

Selon un mode de mise en oeuvre, les opérations d'écriture comprennent une génération de la polarisation de la région implantée verticale avec un potentiel du premier signe non-nul dans la première région de conduction et un potentiel de référence nul dans la deuxième région de conduction, ou avec un potentiel de premier signe non-nul dans la deuxième région de conduction et un potentiel de référence nul dans la première région de conduction.

Selon un mode de mise en oeuvre, les opérations d'écriture comprennent en outre une génération de conditions de programmation produisant une injection de porteurs chauds de charge du deuxième signe, par exemple le signe négatif, dans l'interface diélectrique, depuis une région de canal formée le long desdits flancs de la grille de commande dans le substrat semiconducteur comme source de porteur de charge du deuxième signe.

Selon un mode de mise en oeuvre, les opérations d'écriture comprennent en outre une génération des conditions de programmation comprenant une polarisation de la grille de commande à un potentiel du deuxième signe.

Selon un mode de mise en oeuvre :
- ladite formation de la grille de commande et ladite formation de l'interface diélectrique comprennent une gravure d'une tranchée s'enfonçant verticalement dans le substrat semiconducteur ; et
- ladite formation de la région implantée verticale du deuxième type de dopants comprend, avant les formations des matériaux respectifs de l'interface diélectrique et de la grille de commande dans la tranchée :
   -- une formation d'un corps sacrificiel dopé du deuxième type de dopants remplissant la tranchée ;
   -- une diffusion des dopants du corps sacrificiel dans le substrat semiconducteur le long des flancs de la tranchée ;
   -- un retrait du corps sacrificiel de la tranchée.

Selon un mode de mise en oeuvre, la région implantée verticale est dopée avec une concentration en dopants du deuxième type comprise entre 5*10¹⁵ at/cm³ et 10¹⁸ at/cm³, le substrat semiconducteur étant dopé avec une concentration en dopants du premier type inférieure à 5*10¹⁵ at/cm³.

Et par exemple, la première région de conduction peut être dopée avec une concentration en dopants du deuxième type comprise entre 10¹⁸ at/cm³ et 10²⁰ at/cm³ ; la deuxième région de conduction peut être dopée avec une concentration en dopants du deuxième type comprise entre 5*10¹⁵ at/cm³ et 10¹⁸ at/cm³.

Selon un mode de mise en oeuvre, la fabrication de chaque cellule mémoire comprend en outre :
- une formation d'une grille de sélection dans une tranchée s'étendant verticalement dans le substrat semiconducteur ;
ladite formation de la grille de commande étant faite dans ladite tranchée par-dessus la grille de sélection.

D'autres avantages et caractéristiques de l'invention apparaîtront à l'examen de la description détaillée de modes de réalisation et de mise en oeuvre, nullement limitatifs, et des dessins annexés, sur lesquels les figures :
[Fig 1];
[Fig 2];
[Fig 3];
[Fig 4];
[Fig 5];
[Fig 6A];
[Fig 6B];
[Fig 6C];
[Fig 6D];
[Fig 7];
[Fig 8];
[Fig 9];
[Fig 10];
[Fig 11];
[Fig 12];
[Fig 13];
[Fig 14];
[Fig 15A];
[Fig 15B];
[Fig 15C];
[Fig 16A];
[Fig 16B];
[Fig 16C];
[Fig 16D];
[Fig 17A];
[Fig 17B];
[Fig 17C];
[Fig 17D];

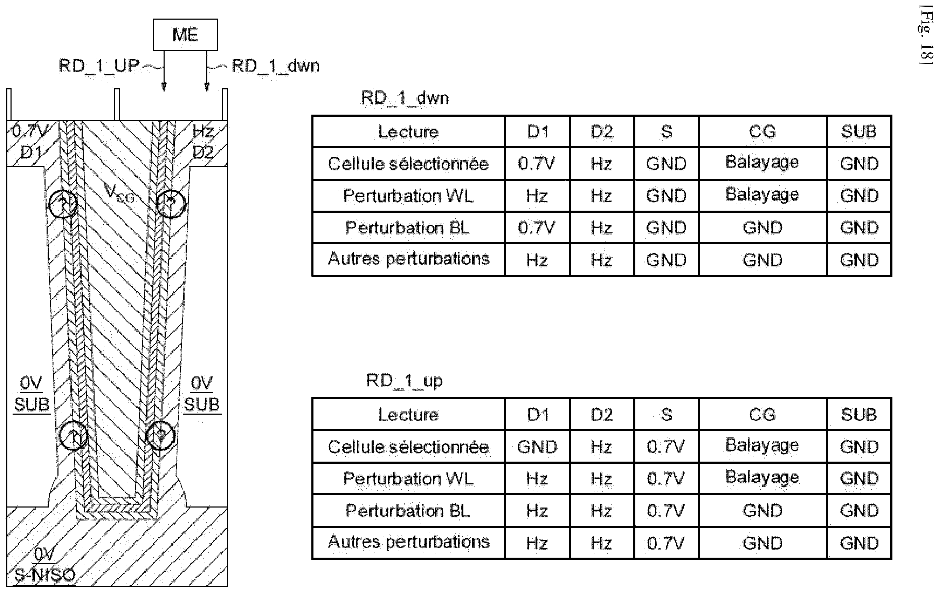

[Fig 18] illustrent des modes de réalisation et de mise en oeuvre de l'invention.

Les figures 1 à 12 illustrent des résultats d'étapes d'un procédé de fabrication de cellules-mémoires de type à piégeage de charges « SONOS » (acronyme des termes usuels « silicium oxyde nitrure oxyde silicium » bien connus de l'homme de l'art) telles que représentées par les figures 13 et 14.

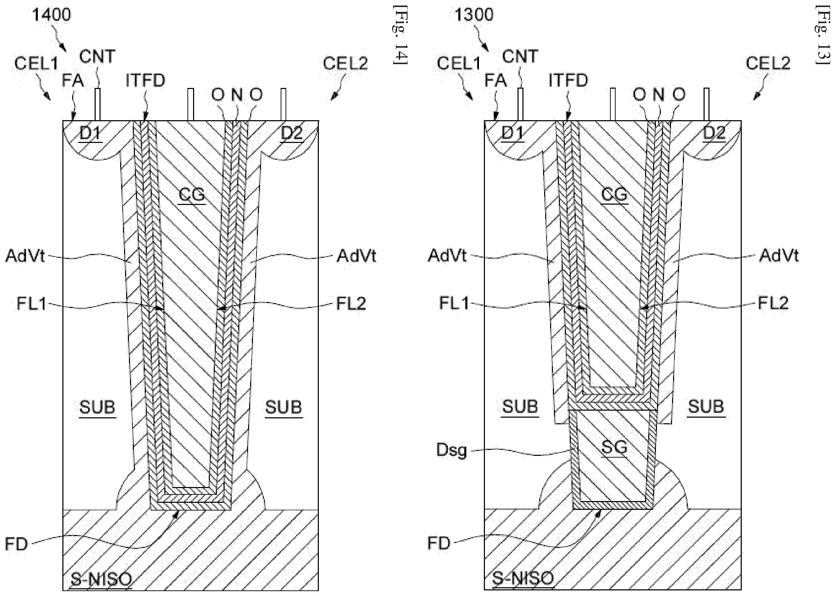

On se réfère à cet égard à la figure 13.

La figure 13 illustre un exemple de réalisation d'un dispositif de mémoire non-volatile comportant des cellules-mémoires CEL1, CEL2 de type « SONOS ».

Une grille de commande CG est verticalement enterrée dans un substrat semiconducteur SUB dopée d'un premier type de dopants, par exemple le type P.

La grille de commande CG est à cet égard avantageusement formée dans une ouverture, appelée tranchée, gravée verticalement en profondeur dans le substrat SUB, à partir d'une face avant FA du substrat.

La grille de commande CG peut avantageusement être commune à deux cellules-mémoires CEL1, CEL2, usuellement désignées respectivement « cellule impaire » CEL1 et « cellule paire » CEL2. Les deux cellules-mémoires CEL1, CEL2 sont situées de part et d'autre (horizontalement) de la grille de commande verticale CG.

Une interface diélectrique ITFD apte à piéger des charges électriques recouvre les flancs de la grille de commande CG en regard du substrat semiconducteur SUB.

Une interface diélectrique ITFD est à cet égard avantageusement formée dans ladite tranchée contenant la grille de commande CG, avant la formation de la grille de commande CG de manière à envelopper la grille de commande CG sur les flancs FL1, FL2 et le fond de la grille de commande CG.

Par exemple, l'interface diélectrique ITFD comporte une succession de couches d'oxyde de silicium O, de nitrure de silicium N, et d'oxyde de silicium O. Sommairement, la couche de nitrure de silicium N est aptes à stocker les charges électriques dans des « pièges de charges » tandis que les couches d'oxyde O ont une fonctionnalité d'isolation électrique du type oxyde de grille.

Chaque cellule-mémoire CEL1, CEL2 comporte en outre une région implantée verticale AdVt d'un deuxième type de dopants opposé au premier type, c'est-à-dire le type N dans cet exemple, située dans le substrat semiconducteur SUB, le long des flancs FL1, FL2 de la grille de commande CG et ainsi le long de l'interface diélectrique ITFD.

Dans l'absolu, étant donné que chacune des deux cellules mémoires CEL1, CEL2 est située du côté d'un flanc respectif de la grille de commande CG, la région implantée verticale AdVt des cellules mémoires CEL1, CEL2 respectives est située dans le substrat SUB le long du flanc respectif FL1, FL2, et le long de l'interface diélectrique ITFD respective.

Par ailleurs, les cellules mémoires CEL1, CEL2 comportent chacune une première région de conduction D1, D2 dopée du deuxième type de dopants (le type N dans cet exemple), par exemple la région de drain, située dans le substrat SUB au niveau d'une surface supérieure du substrat, c'est-à-dire la face avant FA, et du côté respectif de la grille de commande CG.

La face avant FA du substrat SUB correspond à la surface sur laquelle sont couplés des contacts métalliques CNT, reliant des éléments du substrat semiconducteur (D1, CG, D2), avec des pistes de métaux d'un réseau d'interconnexion (non-représenté, classique et connu en soi).

D'autre part, les cellules mémoires CEL1, CEL2 comportent une deuxième région de conduction S-NISO dopée du deuxième type de dopants (le type N dans cet exemple), par exemple la région de source, située dans le substrat SUB en profondeur au niveau du fond FD de la tranchée contenant la grille de commande CG.

Par exemple la deuxième région de conduction S-NISO appartient à un « plan de source », c'est-à-dire une région implantée en profondeur dans le substrat, du type caisson d'isolation (« NISO ») d'une structure du type triple-caisson.

En outre, dans cet exemple, les cellules mémoires CEL1, CEL2 comportent une grille de sélection SG, elle-aussi dans la tranchée contenant la grille de commande CG, entre la grille de commande CG et le fond FD de la tranchée.

La grille de sélection SG est électriquement isolée du substrat SUB et de la région de source S-NISO par une enveloppe diélectrique de grille Dsg. La grille de sélection SG est également isolée de la grille de commande par une couche diélectrique.

Par exemple, en pratique :
- le substrat semiconducteur SUB, typiquement en silicium, peut être dopée avec du bore à une concentration comprise entre 10¹⁴ et 5*10¹⁵ at/cm³ ;
- les premières régions de conduction D1, D2 peuvent être dopées avec de l'arsenic à une concentration comprise entre 10¹⁸ et 10²⁰ at/cm³ ;
- la deuxième région de conduction S-NISO peut être dopée avec du phosphore à une concentration comprise entre 5*10¹⁵ et 10¹⁸ at/cm³
- les régions implantées verticales AdVt peuvent être dopées avec du phosphore (ou bien de l'arsenic) à une concentration comprise entre 5*10¹⁵ et 10¹⁸ at/cm³.

La figure 14 illustre un exemple de réalisation d'un dispositif de mémoire non-volatile comportant des cellules-mémoires CEL1, CEL2 de type « SONOS », en alternative à celui décrit en relation avec la figure 13.

Dans cette alternative, les cellules mémoires CEL1, CEL2 ne comportent pas la grille de sélection SG, ni l'enveloppe diélectrique de grille Dsg correspondante.

Les autres éléments du dispositif et des cellules mémoires CEL1, CEL2 supportent les mêmes références, et tout le reste de la description donnée en relation avec la figure 13 s'applique à l'alternative de la figure 14.

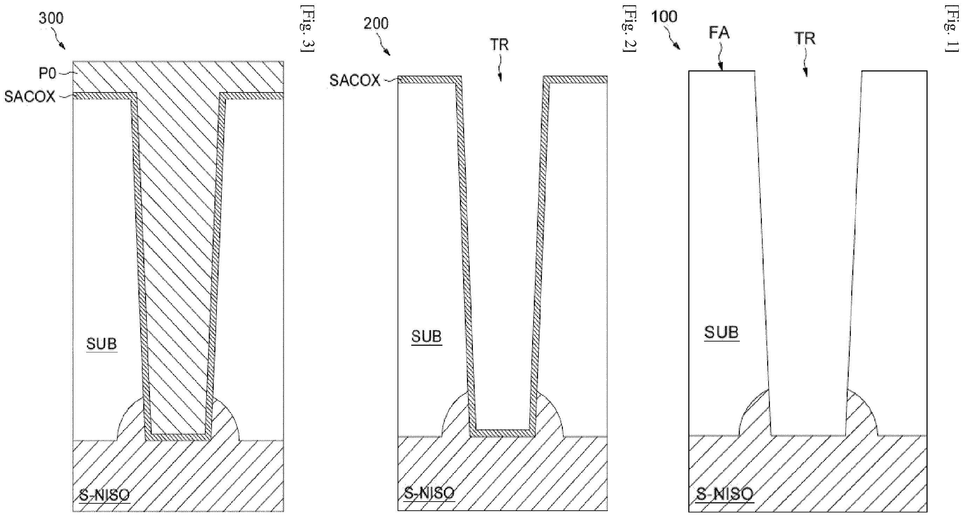

On se réfère désormais aux figures 1 à 12.

La figure 1 illustre le résultat d'une étape 100 de gravure de la tranchée TR dans le substrat semiconducteur SUB, dopé du premier type de dopant, c'est-à-dire par exemple le type P, et comportant la région S-NISO dopée du type N implantée en profondeur dans le substrat SUB.

La figure 2 illustre le résultat d'une étape 200 de formation d'une couche d'oxyde « sacrificiel » SACOX, sur les flancs et le fond de la tranchée TR. La couche d'oxyde sacrificiel SACOX formera néanmoins l'oxyde de grille Dsg (figure 13) de la future grille de sélection SG (figure 3 et suivantes). Par exemple la couche d'oxyde sacrificiel SACOX peut avoir une épaisseur comprise entre 5 nm et 10 nm.

La figure 3 illustre le résultat d'une étape 300 de formation d'un premier matériau conducteur de grille P0, par exemple en silicium polycristallin dopé. Le premier matériau de grille P0 est déposé en excès de manière à remplir la tranchée et déborder aussi dessus de la face avant FA.

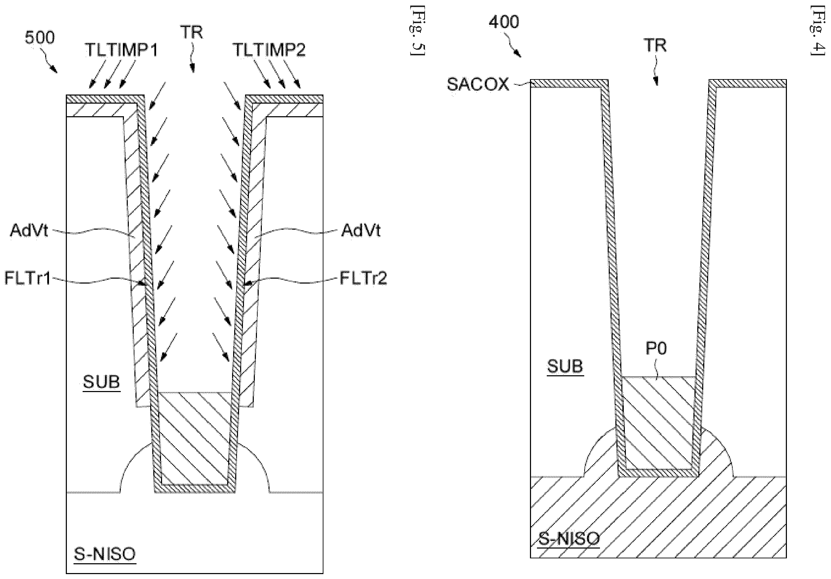

La figure 4 illustre le résultat d'une étape 400 de gravure retirant le premier matériau de grille P0 sur une hauteur inférieure à la profondeur de la tranchée TR, par exemple une hauteur comprise entre 50% et 90% de la profondeur de la tranchée. Par exemple la gravure 400 est mise en oeuvre pendant une durée paramétrée à cet égard en fonction de la vitesse de gravure. En outre la gravure 400 est configurée pour être sélective vis-à-vis de l'oxyde de silicium, de manière à ne pas graver ou très peu graver la couche d'oxyde sacrificielle SACOX afin de protéger le substrat SUB contre cette gravure 400.

La figure 5 illustre le résultat d'un premier exemple d'une étape 500 de formation d'une région implantée verticale AdVt du deuxième type de dopants, c'est-à-dire le type N, dans le substrat semiconducteur SUB, et située le long des flancs FLTr1, FLTr2 de la tranchée TR.

Dans ce premier exemple, on peut obtenir cette orientation verticale de la région implantée AdVt en mettant en oeuvre une première implantation inclinée TLTIMP1 de manière à exposer obliquement un premier flanc de la tranchée FLTr1, et une deuxième implantation inclinée TLTIMP2 de manière à exposer obliquement un deuxième flanc de la tranchée FLTr2.

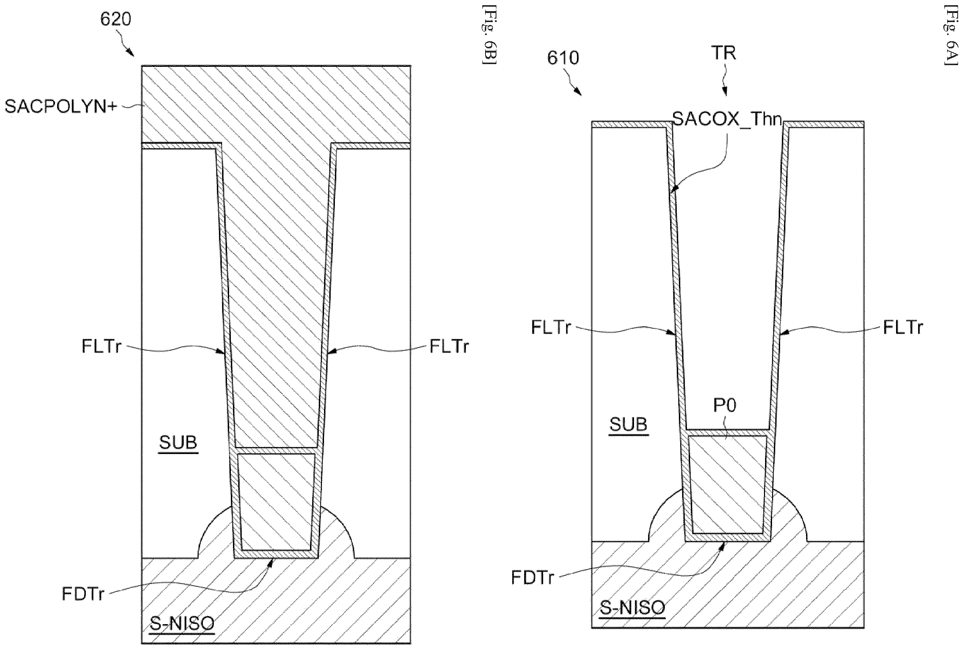

Les figures 6A à 6D illustre un deuxième exemple, préférentiel, de formation d'une région implantée verticale AdVt du deuxième type de dopants, c'est-à-dire le type N, dans le substrat semiconducteur SUB, le long des flancs FLTr1, FLTr2 de la tranchée TR.

En effet, il peut être difficile de réaliser une implantation de canal uniforme, à la verticale le long des parois latérales de la tranchée, notamment en fonction du facteur de forme en utilisant les techniques d'implantation inclinée. Le deuxième exemple décrit permet avantageusement de former la région implantée verticale AdVt uniforme autour des tranchées verticales.

La figure 6A illustre le résultat d'une étape 610 de formation d'une couche fine d'oxyde sacrificiel SACOX_Thn, sur les flancs FLTr, FLTr et le fond d'une tranchée TRd déjà formée.

En particulier, la couche fine d'oxyde sacrificiel SACOX_Thn est plus fine que la couche d'oxyde sacrificiel SACOX décrite précédemment en relation avec la figure 2. Par exemple, la couche fine d'oxyde sacrificiel SACOX_Thn a une épaisseur inférieure à 5 nm. En particulier, la couche fine d'oxyde sacrificiel SACOX_Thn n'est pas destinée à former une région de diélectrique de grille, et n'a pas la contrainte d'une épaisseur minimale à cet égard.

Dans un mode de mise en oeuvre correspondant à l'exemple de la figure 13, la tranchée TRd déjà formée peut correspondre à la tranchée TR de la figure 4, dans laquelle la couche d'oxyde sacrificiel SACOX est retirée partout où elle n'est pas recouverte par le premier matériau de grille P0.

Dans un mode de mise en oeuvre correspondant à l'exemple de la figure 14, la tranchée TRd déjà formée peut correspondre à la tranchée TR de la figure 1.

La figure 6B illustre le résultat d'une étape 620 de formation d'un corps sacrificiel fortement dopé du deuxième type de dopants SACPOLYN+, c'est-à-dire le type N, dans la tranchée déjà formée TRd. Par exemple le corps sacrificiel SACPOLYN+ est formé avec un matériau conducteur de grille, tel que le silicium polycristallin, et par exemple de la manière décrite précédemment en relation avec la figure 3.

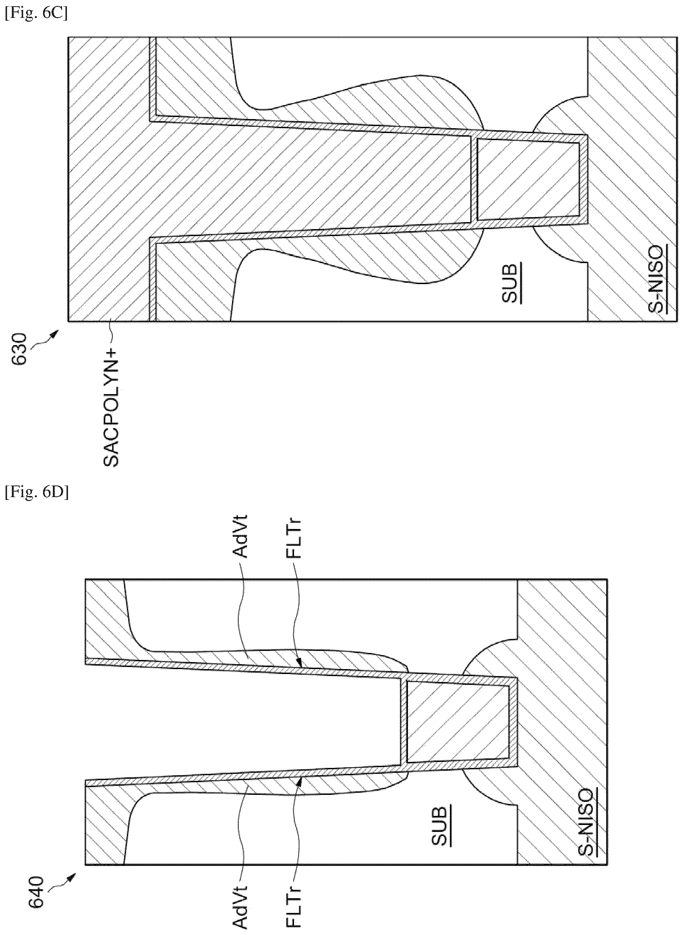

La figure 6C illustre le résultat d'une étape 630 de diffusion des dopants du type N, du corps sacrificiel SACPOLYN+ vers le substrat semiconducteur SUB à travers la couche fine d'oxyde sacrificiel SACOX_Thn.

A l'issue de la diffusion 630, le profil du dopage de type N, c'est-à-dire la variation spatiale de la concentration des dopants dans le substrat SUB, peut avoir une forme « de goutte » causée par la forme aiguë de la tranchée.

La figure 6D illustre le résultat d'une étape 640 dans laquelle on a mis en oeuvre des recuits et stabilisation des dopants, de sorte que le profil du dopage de type N obtenu par la diffusion de l'étape 630 est uniformisé le long des flancs FLTr de la tranchée TRd.

En outre, l'étape 640 comprend un retrait du corps sacrificiel, par exemple selon le même type de gravure que décrit précédemment en relation avec la figure 4.

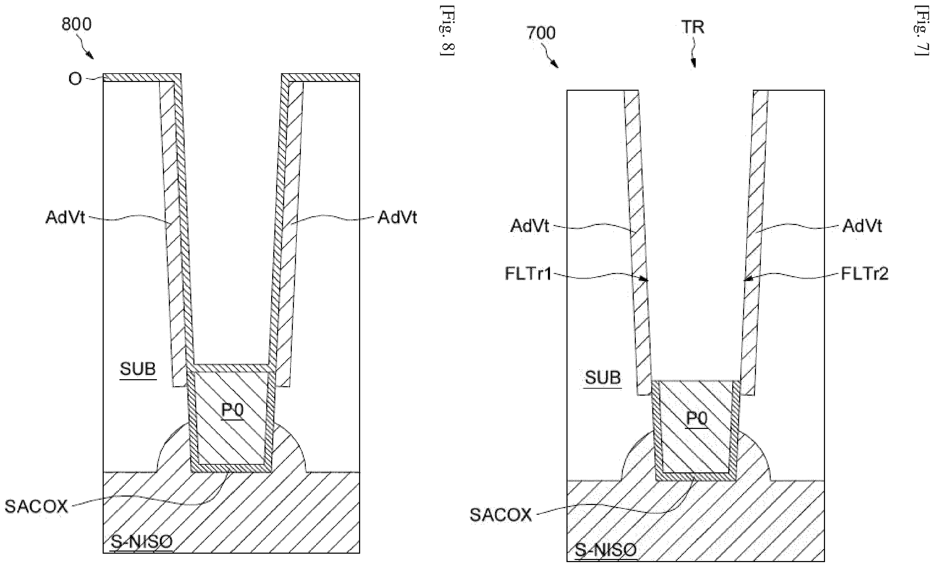

La figure 7 illustre le résultat d'une étape 700, après la formation 500, 610-640 de la région implantée verticale AdVt du type N située dans le substrat semiconducteur SUB, le long des flancs FLTr1, FLTr2 de la tranchée TR, c'est-à-dire le long des flancs de la future grille de commande CG et le long de la future interface diélectrique de piégeage de charges ITFD.

L'étape 700 correspond au retrait de la couche d'oxyde sacrificiel SACOX partout où elle n'est pas recouverte par le premier matériau de grille P0, dans un mode de mise en oeuvre correspondant à l'exemple de la figure 13 (après la formation 500 décrite en relation avec la figure 5) ; ou bien au retrait de la couche fine d'oxyde sacrificiel SACOX_Thn, optionnellement dans un mode de mise en oeuvre correspondant à l'exemple de la figure 14 (après la formation 610-640 décrite en relation avec les figures 6A à 6D).

La figure 8 illustre le résultat d'une étape 800 de formation d'une première couche d'oxyde de silicium O, par exemple au moyen d'un dépôt conforme, c'est-à-dire un dépôt d'une épaisseur uniforme et constante de la couche O, quelle que soit l'orientation (verticale ou horizontale) de la surface de dépôt.

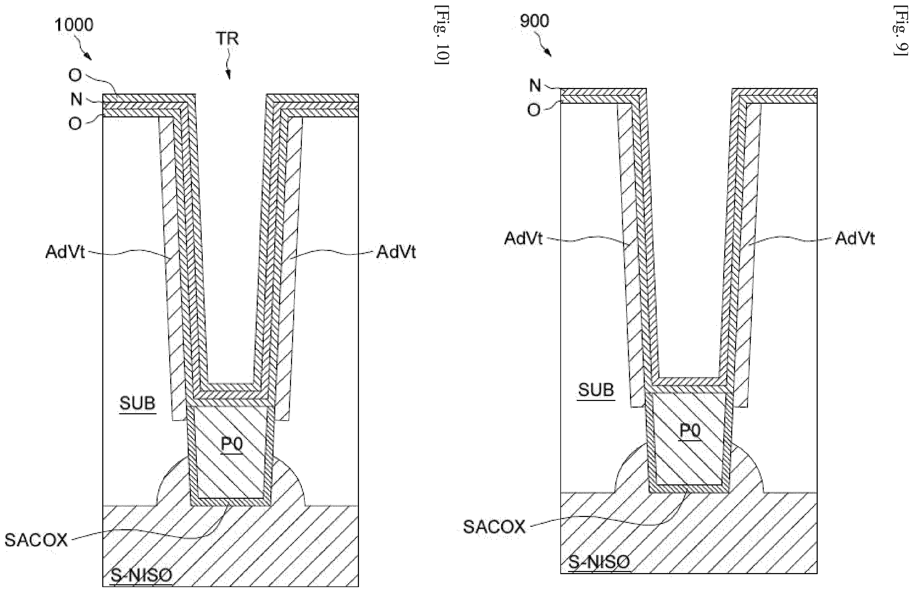

La figure 9 illustre le résultat d'une étape 900 de formation d'une couche de nitrure de silicium N, de manière conforme sur la première couche d'oxyde O.

La figure 10 illustre le résultat d'une étape 1000 de formation d'une deuxième couche d'oxyde de silicium 0, de manière conforme sur la couche de nitrure N.

Par exemples, chacune des couches d'oxyde et de nitrure de l'empilement ONO peut avoir une épaisseur comprise entre 5 nm et 10 nm.

A l'issue des étapes 800, 900, 1000 décrites en relation avec les figures 8, 9 et 10, on a formé une interface diélectrique ITFD apte à piéger des charges électriques, en particulier dans des « pièges de charges » de la couche de nitrure de silicium N. L'interface diélectrique est destinée à recouvrir les flancs de la future grille de commande CG en regard du substrat semiconducteur SUB.

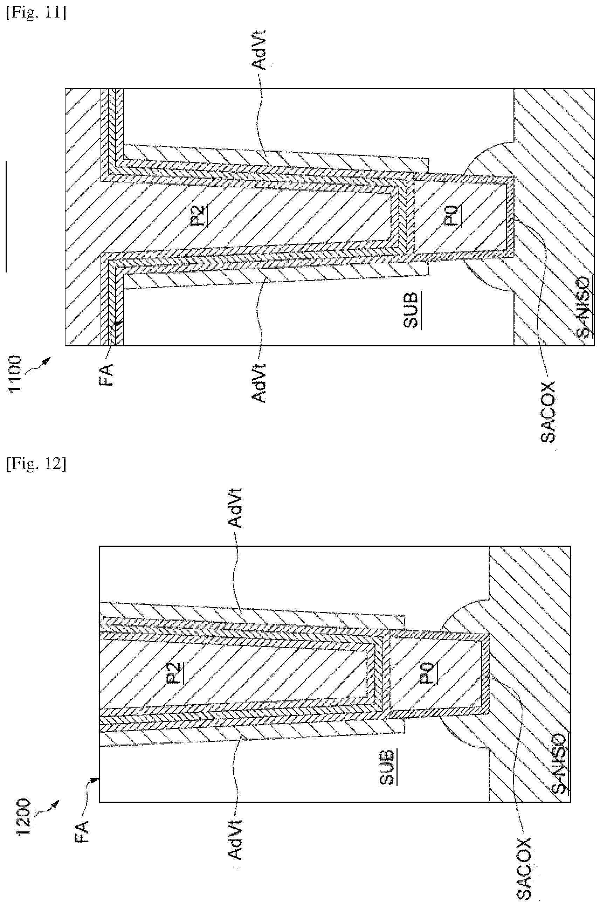

La figure 11 illustre le résultat d'une étape 1100 de formation d'un deuxième matériau conducteur de grille P2, par exemple en silicium polycristallin dopé.

Le deuxième matériau de grille P2 est déposée en excès de manière à remplir la tranchée TR, c'est-à-dire le volume restant à l'intérieur de la tranchée TR entre les flancs et le fond de l'empilement des couches diélectriques ONO de l'interface ITFD, et déborder sur l'empilement des couches diélectriques ONO, au-dessus la face avant FA.

La figure 12 illustre le résultat d'une étape 1200 de « planarisation » (anglicisme usuel issu du terme anglais « planarization ») dans laquelle on a retiré toutes les couches situées au-dessus de la face avant FA du substrat SUB.

Ce type de retrait 1200 est par exemple mis en oeuvre par une technique d'aplanissement chimio-mécanique « CMP » (acronymes des termes anglais usuels « chemical-mechanical planarization »).

On a ainsi formé, avec le deuxième matériau de grille P2, la structure de grille de commande CG verticale enterrée dans le substrat SUB, telle que décrite précédemment en relation avec les figures 13 ou 14 ; et, avec le premier matériau de grille P0, on a formé la structure de grille de sélection SG, telle que décrite précédemment en relation avec la figure 13.

Ainsi, après des étapes 1300 d'implantation des régions de drains D1, D2, de formation des contacts métalliques CNT et du reste de la chaine de fabrication des circuits intégrés, on a obtenu le dispositif de mémoire décrit précédemment en relation avec la figure 13 en cas de présence de la grille de sélection SG, ou avec la figure 14 en cas d'absence de la grille de sélection SG.

Par ailleurs, on notera que chaque grille de sélection SG peut être commune à un groupe de cellules-mémoires paires et impaires CEL1, CEL2, usuellement nommé « page », typiquement une ligne de l'organisation physique d'un plan mémoire contenant toutes les cellules mémoires, et comportant des sous-ensembles nommés « mots ». Les mots peuvent par exemple comporter un ou plusieurs octets, et avoir une grille de commandes CG commune aux cellules-mémoires paires et impaires CEL1, CEL2 appartenant à un même mot.

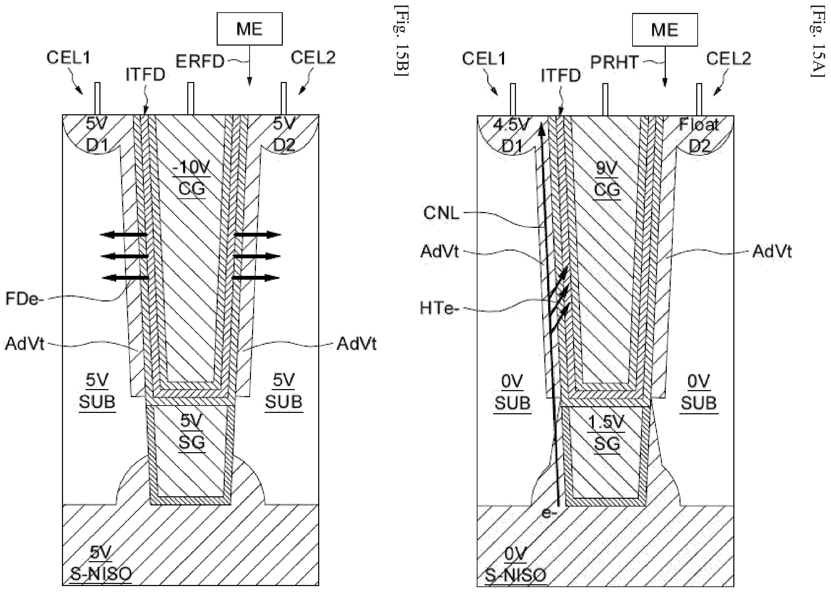

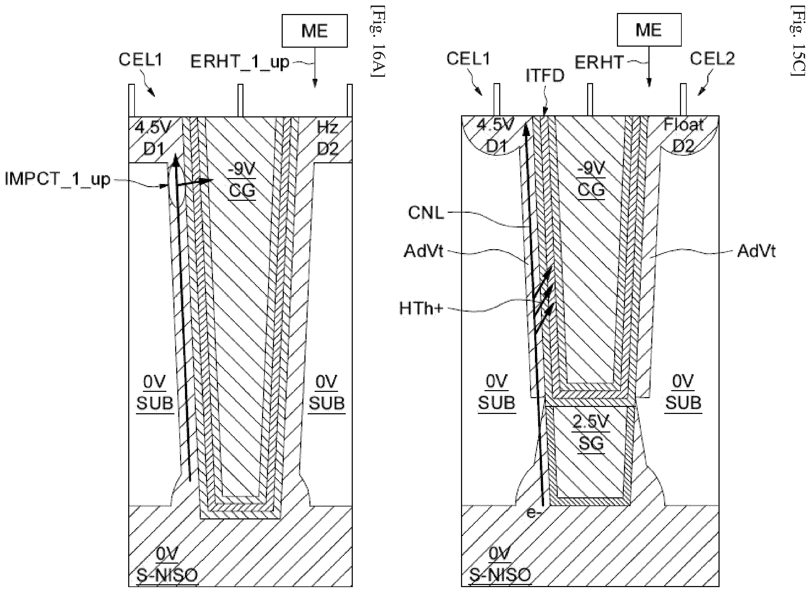

Les figures 15A, 15B et 15C illustrent les principes des opérations d'écriture, comportant typiquement une programmation et/ou un effacement, dans l'exemple de la cellule mémoire CEL1 décrite précédemment en relation avec la figure 13.

Dans la suite de la présente description, on considère par convention qu'une programmation d'une cellule mémoire correspond à l'écriture de la donnée « 0 » (selon un exemple de convention arbitraire), tandis qu'un effacement d'une cellule mémoire correspond à l'écriture de la donnée « 1 » (selon le même exemple). On considère aussi par convention que la programmation est obtenue par piégeage de charge ayant le signe négatif, c'est-à-dire des électrons ; et que l'effacement est obtenu par expulsion des charges négatives piégées, ou bien avantageusement par une injection de charges de signe positif, c'est-à-dire des trous, recombinant avec des charges négatives piégées.

Par convention également, et en cohérence avec l'exemple donné précédemment en relation avec les figures 1 à 14 selon lequel le premier type de dopants est le type P tandis que le deuxième type de dopants et le type N, on considère que le signe positif des charges et des potentiels (en volts) est le « premier signe », tandis que le signe négatif des charges et des potentiels (en volts) est le « deuxième signe ».

La figure 15A illustre des conditions de programmation PRHT produisant une injection de porteurs chauds de charge négative, c'est-à-dire des « électrons chauds » HTe-, dans des pièges de charges de l'interface diélectrique ITFD.

Les conditions de programmation PRHT comprennent une polarisation de la grille de commande CG à un potentiel positif de haute tension, par exemple sensiblement +9 V (volts), de sorte que les électrons chauds HTe- peuvent provenir d'une région de canal CNL formée le long des flancs de la grille de commande CG dans le substrat semiconducteur. La région de canal CNL forme ainsi la source des porteurs chauds de charge négative.

En outre, les conditions de programmation PRHT peuvent comprendre une polarisation du drain D 1 de la cellule-mémoire sélectionnée CEL1 à un potentiel positif modéré, par exemple sensiblement +4,5V ; une application d'un potentiel d'activation dans la grille de sélection SG apte à engendrer la continuité de la région de canal CNL le long de la grille de sélection SG jusqu'à la source S-NISO, par exemple de sensiblement 1,5 V ; une polarisation de la source S-NISO et du substrat SUB à une tension de référence nulle 0 V ; ainsi que laisser flottant le potentiel dans les drains D2 de toutes les autres cellules mémoires CEL2, ainsi qu'un potentiel bloquant, par exemple 0 V, dans les grilles de sélection non-sélectionnées.

La figure 15B illustre des conditions d'effacement « global » ERFD produisant une extraction des charges stockées dans les pièges de charges de l'interface diélectrique ITFD par effet Fowler-Nordheim.

Ces conditions d'effacement global ERFD comprennent une polarisation de la grille de commande CG à un potentiel négatif de haute tension dite partagée, par exemple sensiblement -10 V, et une polarisation du substrat SUB à une tension positive modérée elle-aussi partagée, par exemple de sensiblement +5 V, de sorte que les électrons piégés sont expulsés des pièges de la couche de nitrure N vers le substrat SUB.

Par ailleurs, les conditions d'effacement global par effet Fowler-Nordheim ERFD peuvent comprendre en outre une polarisation des drains D1, D2, de la grille de sélection SG et de la source S-NISO de toutes les cellules mémoires de la rangée effacée (sélectionnée) au potentiel positif partagée de sensiblement 5 V.

Les conditions de l'effet Fowler-Nordheim étant obtenues entre la grille de commande CG et le substrat SUB, toutes les cellules-mémoires paires et impaires CEL1, CEL2 appartenant à une même rangée sont effacées par ces conditions ERFD. Cela est désavantageux en soi.

La figure 15C illustre des conditions préférentielles d'effacement ERHT produisant avantageusement une injection de porteurs chauds de charge positive, c'est-à-dire des « trous chauds » HTh+, dans les pièges de charges de l'interface diélectrique ITFD, recombinant avec des charges négatives piégées dans lesdits pièges.

Les conditions préférentielles d'effacement ERHT présentent l'avantage d'être sélective par bit, c'est-à-dire que chaque bit de chaque cellule-mémoire CEL1 peut être effacé sélectivement par rapport aux autres bits des cellules-mémoires CEL2 de la même rangée ou du même mot mémoire.

En effet, les conditions préférentielles d'effacement ERHT comprennent une polarisation de la grille de commande CG à un potentiel négatif de haute tension, par exemple sensiblement -9 V (volts). Ce fort potentiel négatif de grille de commande CG bloque la formation d'une région de canal CNL dans le substrat SUB. Cependant, malgré l'absence de la région de canal CNL (et donc de la source de porteurs de charges telle que pour la programmation PRHT), un fort courant peut circuler dans les régions verticales implantée AdVt, à condition d'avoir un potentiel de drain D1 suffisamment élevé. Le fort potentiel positif de drain D1 engendre une création de trous chauds HTh+ par ionisation par impact. Le courant circulant dans la région implantée verticale AdVt de la cellule impaire CEL1 forme ainsi la source des porteurs chauds de charge positive HTh+.

En outre, les conditions préférentielles d'effacement ERHT sont sélectives par bit car elles comprennent une polarisation du drain D1 de la cellule-mémoire sélectionnée CEL1 à un potentiel positif modérément élevé, par exemple sensiblement +4,5V.

D'autres part, les conditions préférentielles d'effacement sélectives par bit ERHT comprennent une application d'un potentiel d'activation dans la grille de sélection SG, apte à engendrer une région de canal faisant une continuité électrique entre la région implantée verticale AdVt et la source S-NISO, le long de la grille de sélection SG, par exemple de sensiblement 2,5 V ; une polarisation de la source S-NISO et du substrat SUB à une tension de référence nulle 0 V ; ainsi que laisser flottant le potentiel dans les drains D2 de toutes les autres cellules mémoires CEL2. Les grilles de sélection non-sélectionnées peuvent être portées à un potentiel bloquant, par exemple 0 V.

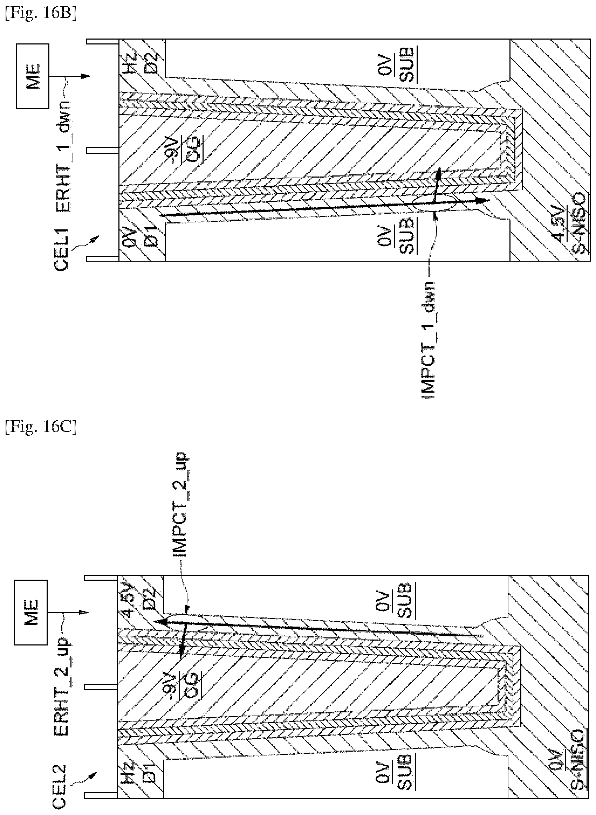

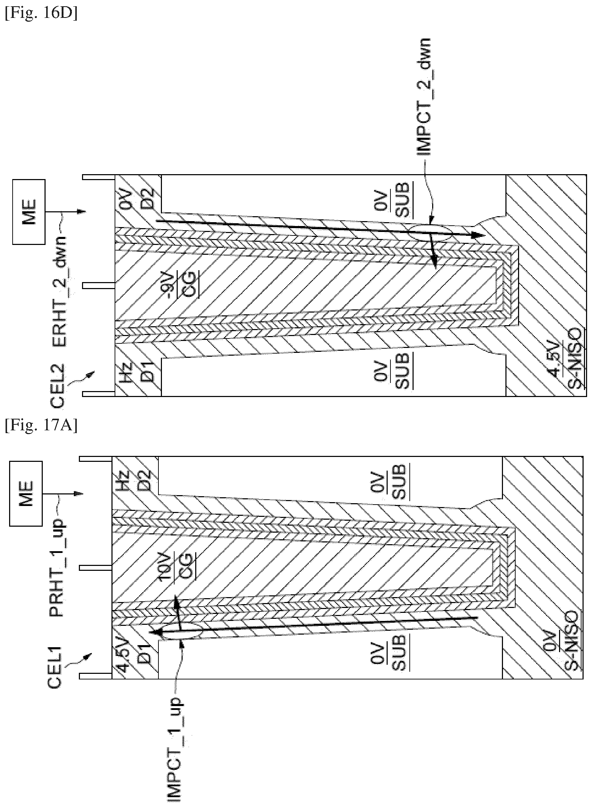

Les figures 16A, 16B, 16C et 16D illustrent les conditions préférentielles d'effacement ERHT, sélectives par bit, dans le cas des réalisation des cellules mémoires sans la grille de sélection SG, tel que décrit précédemment en relation avec la figure 14.

Les figures 16A à 16D illustrent en outre une autre faculté avantageuse des conditions préférentielles d'effacement ERHT, permettant un stockage de deux bits indépendants dans une même cellule-mémoire impaire CEL1 ou paire CEL2.

En effet, on peut à cet égard générer :
- des premières conditions d'effacement ERHT_1_up pour la cellule-mémoire impaire CEL1 (figure 16A),
- des premières conditions d'effacement ERHT_2_up pour la cellule-mémoire paire CEL2 (figure 16C),
- des deuxièmes conditions d'effacement ERHT_1_dwn pour la cellule-mémoire impaire CEL1 (figure 16B),
- des deuxièmes conditions d'effacement ERHT_2_dwn pour la cellule-mémoire paire CEL2 (figure 16D).

La figure 16A illustre les premières conditions d'effacement ERHT_1_up pour la cellule-mémoire impaire CEL1, polarisant la région implantée verticale AdVt avec le potentiel positif non-nul, par exemple 4,5 V, dans la première région de conduction D1 et le potentiel de référence nul, 0 V, dans la deuxième région de conduction S-NISO.

En outre, la haute tension négative, par exemple -9 V, est appliquée dans la grille de commande CG, et la première région de conduction D2 de la cellule mémoire paire CEL2 partageant la même grille de commande CG est laissé à un potentiel flottant à haute impédance Hz.

La figure 16B illustre les deuxièmes conditions d'effacement ERHT_1_dwn pour la cellule-mémoire impaire CEL1, polarisant la région implantée verticale AdVt avec le potentiel de référence nul, 0 V, dans la première région de conduction D1 et le potentiel positif non-nul, par exemple 4,5 V, dans la deuxième région de conduction S-NISO.

En outre, la haute tension négative, par exemple -9 V, est appliquée dans la grille de commande CG, et la première région de conduction D2 de la cellule mémoire paire CEL2 partageant la même grille de commande CG est laissé à un potentiel flottant à haute impédance Hz.

La figure 16C illustre les premières conditions d'effacement ERHT_2_up pour la cellule-mémoire paire CEL2, polarisant la région implantée verticale AdVt avec le potentiel positif non-nul, par exemple 4,5 V, dans la première région de conduction D2 et le potentiel de référence nul, 0 V, dans la deuxième région de conduction S-NISO.

En outre, la haute tension négative, par exemple -9 V, est appliquée dans la grille de commande CG, et la première région de conduction D1 de la cellule mémoire impaire CEL1 partageant la même grille de commande CG est laissé à un potentiel flottant à haute impédance Hz.

La figure 16D illustre les deuxièmes conditions d'effacement ERHT_2_dwn pour la cellule-mémoire paire CEL2, polarisant la région implantée verticale AdVt avec le potentiel de référence nul, 0 V, dans la première région de conduction D2 et le potentiel positif non-nul, par exemple 4,5 V, dans la deuxième région de conduction S-NISO.

En outre, la haute tension négative, par exemple -9 V, est appliquée dans la grille de commande CG, et la première région de conduction D1 de la cellule mémoire impaire CEL1 partageant la même grille de commande CG est laissé à un potentiel flottant à haute impédance Hz.

En effet, selon l'orientation de la tension entre les régions de conductions, par exemple de la source vers le drain dans le cas des premières conditions d'effacement ERHT_1_up, ERHT_2_up, le champ électrique sera le plus grand au niveau de la jonction PN entre le drain D1, D2 et le substrat SUB.

Et, respectivement dans l'orientation de la tension entre les régions de conductions du drain vers la source, dans le cas des deuxièmes conditions d'effacement ERHT_1_dwn, ERHT_2_dwn, le champ électrique sera le plus grand au niveau de la jonction PN entre la source S-NISO et le substrat SUB.

Or, les ionisations par impacts IMPCT_1_up, IMPCT_1_dwn, IMPCT_2_up, IMPCT_2_dwn, c'est-à-dire les générations de porteurs chauds, vont se produire là où le champ électrique est le plus grand, c'est-à-dire au niveau de l'une ou l'autre desdites jonctions PN.

Ainsi, on peut prévoir deux régions distinctes d'ionisation par impact IMPCT_1_up, IMPCT_1_dwn dans une même cellule mémoire impaire CEL1 ; et respectivement deux régions distinctes d'ionisation par impact IMPCT_2_up, IMPCT_2_dwn dans une même cellule mémoire paire CEL2.

Chaque cellule mémoires impaire CEL1 ou paire CEL2 comporte donc deux localités de l'interface diélectrique ITFD pour piéger des charges par injection de trous chauds. Cela permet avantageusement de pouvoir stocker indépendamment deux bits par cellule-mémoire.

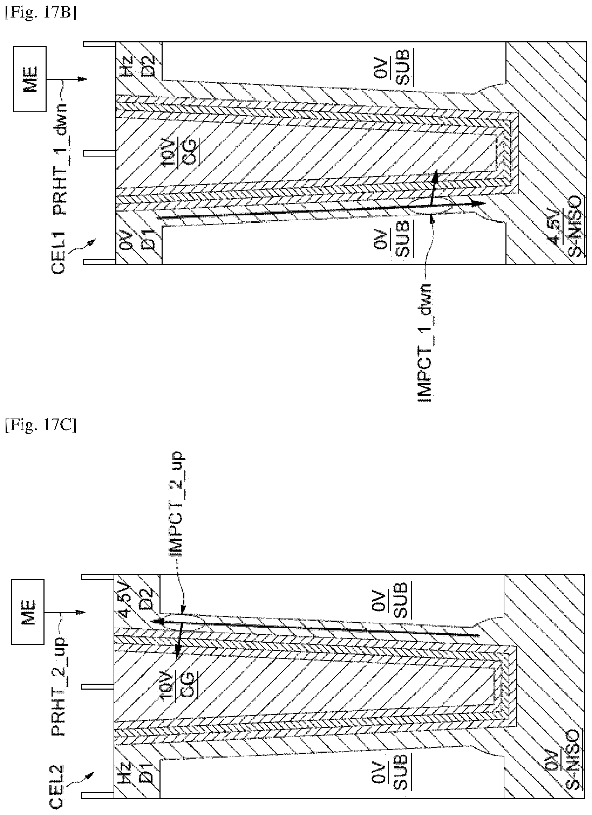

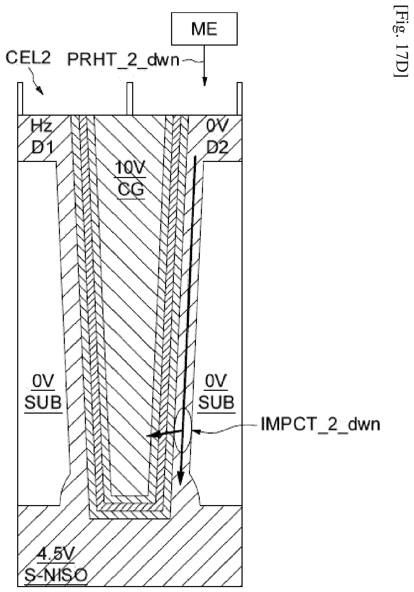

Les figures 17A, 17B, 17C et 17D illustrent les conditions de programmation PRHT, sélectives par bit, dans le cas des réalisations des cellules mémoires sans la grille de sélection SG, tel que décrit précédemment en relation avec la figure 14.

Les conditions de programmation présentent la même faculté avantageuse de stockage de deux bits indépendants dans une même cellule-mémoire impaire CEL1 ou paire CEL2.

On se référera à cet égard à :
La figure 17A qui illustre des premières conditions de programmation PRHT_1_up pour la cellule-mémoire impaire CEL1, pouvant par exemple être identiques aux premières conditions d'effacement ERHT_1_up pour la cellule-mémoire impaire CEL1 mais avec une polarisation de la grille de commande CG avec le potentiel haute tension positif, par exemple +10 V ;
La figure 17B qui illustre des deuxièmes conditions de programmation PRHT_1_dwn pour la cellule-mémoire impaire CEL1, pouvant par exemple être identiques aux deuxièmes conditions d'effacement ERHT_1_dwn pour la cellule-mémoire impaire CEL1 mais avec une polarisation de la grille de commande CG avec le potentiel haute tension positif, par exemple +10 V ;
La figure 17C qui illustre des premières conditions de programmation PRHT_2_up pour la cellule-mémoire paire CEL2, pouvant par exemple être identiques aux premières conditions d'effacement ERHT_2_up pour la cellule-mémoire paire CEL2 mais avec une polarisation de la grille de commande CG avec le potentiel haute tension positif, par exemple +10 V ;
La figure 17D qui illustre des deuxièmes conditions de programmation PRHT_2_dwn pour la cellule-mémoire paire CEL2, pouvant par exemple être identiques aux deuxièmes conditions d'effacement ERHT_2_dwn pour la cellule-mémoire paire CEL2 mais avec une polarisation de la grille de commande CG avec le potentiel haute tension positif, par exemple +10 V.

Les mécanismes de sélectivité et de localisation IMPCT_1_up, IMPCT_1_dwn, IMPCT_2_up, IMPCT_2_dwn, des deux bits par cellule impaire CEL1 et paire CEL2 sont les mêmes en programmation PRHT_1_up, PRHT_1_dwn, PRHT_2_up, PRHT_2_dwn, que décrit précédemment en relation avec les figures 16A-16D pour l'effacement ERHT_1_up, ERHT_1_dwn, ERHT_2_up, ERHT_2_dwn.

La figure 18 illustre d'une part dans un tableau RD_1_up, les conditions permettant d'accéder en lecture sélectivement au premier bit (IMPCT_1_up) de la cellule mémoire impaire CEL1, et d'autre part dans un tableau RD_1_dwn, les conditions permettant d'accéder en lecture sélectivement au deuxième bit (IMPCT_1_dwn) de la cellule mémoire impaire CEL1.

Les conditions d'accès en lecture des deux bits de la cellule mémoires paire CEL2 s'obtiennent en inversant les polarisations entre les régions de drains D1 et D2 des tableaux RD_1_up et RD_1_dwn.

Par ailleurs, des moyens d'écriture ME de conception classique et non-représentés sont prévus pour mettre en oeuvre les opérations d'écriture ERHT, ERFD, PRTH, ERHT_1_up, ERHT_1_dwn, ERHT_2_up, ERHT-2-dwn, PRTH_1_up, PRTH_1_dwn, PRTH-2-up, PRTH_2_up, et de lecture RD_1_dwn, RD_1_up telles que décrites ci-avant en relation avec les figures 15A à 18, et peuvent par exemple comporter un générateur haute tension du type pompe de charge, une logique de transmission des hautes tensions vers les cellules-mémoires, et une logique du type machine d'états pour cadencer et commander les opérations d'écriture et de lecture.

En résumé, il a été décrit une mémoire non-volatile du type à piégeage de charges, dans laquelle une seule structure verticale de grille de commande CG, éventuellement superposée à une grille de sélection SG dans une tranchée, ayant donc une très faible empreinte surfacique au niveau de la face avant FA du substrat SUB, permet d'accéder à 4 bits, chacun de ces quatre bits étant accessible sélectivement et individuellement en effacement, en programmation, ainsi qu'en lecture.

## Revendications

1. Dispositif de mémoire non-volatile comportant des cellules mémoires (CEL1, CEL2) comportant une grille de commande (CG) verticalement enterrée dans un substrat semiconducteur (SUB) dopé d'un premier type de dopants, et une interface diélectrique (ITFD) apte à piéger des charges électriques recouvrant des flancs (FL1, FL2) de la grille de commande (CG) en regard du substrat semiconducteur, comportant en outre une région implantée verticale (AdVt) d'un deuxième type de dopants opposé au premier type située le long desdits flancs de la grille de commande (FL1, FL2) dans le substrat semiconducteur (SUB).

2. Dispositif selon la revendication 1, dans lequel chaque cellule mémoires (CEL1, CEL2) comporte une première région de conduction (D1, D2) dopée du deuxième type de dopants, située dans le substrat (SUB) au niveau d'une surface supérieure (FA) et d'un côté de la grille de commande (CG), et une deuxième région de conduction (S-NISO) dopée du deuxième type de dopants, située dans le substrat (SUB) en profondeur au niveau du fond d'une tranchée (FD) contenant la grille de commande (CG).

3. Dispositif selon l'une des revendications 1 ou 2, comportant en outre des moyens d'écriture (ME) configurés pour générer des conditions d'effacement (ERHT) adaptées à une injection de porteurs chauds de charge d'un premier signe, dans l'interface diélectrique (ITFD), depuis ladite région implantée verticale (AdVt) comme source de porteurs de charge du premier signe.

4. Dispositif selon la revendication 3, dans lequel les moyens d'écriture (ME) sont configurés pour générer les conditions d'effacement (ERHT) comprenant une polarisation de la grille de commande (CG) à un potentiel d'un deuxième signe, et une polarisation de la région implantée verticale (AdVt) à un potentiel du premier signe.

5. Dispositif selon la revendication 4 prise en combinaison avec la revendication 2, dans lequel les moyens d'écriture (ME) sont configurés pour générer la polarisation de la région implantée verticale (AdVt) avec un potentiel du premier signe non-nul dans la première région de conduction (D1) et un potentiel de référence nul dans la deuxième région de conduction (S-NISO), ou avec un potentiel de premier signe non-nul dans la deuxième région de conduction (S-NISO) et un potentiel de référence nul dans la première région de conduction (D1).

6. Dispositif selon l'une des revendications 3 à 5, dans lequel les moyens d'écriture (ME) sont en outre configurés pour générer des conditions de programmation (PRHT) adaptées à une injection de porteurs chauds de charge du deuxième signe, dans l'interface diélectrique (ITFD), depuis une région de canal (CNL) formée le long desdits flancs de la grille de commande (CG) dans le substrat semiconducteur (SUB) comme source de porteur de charge du deuxième signe.

7. Dispositif selon la revendication 6, dans lequel les moyens d'écriture (ME) sont en outre configurés pour générer les conditions de programmation (PRHT) comprenant une polarisation de la grille de commande (CG) à un potentiel du deuxième signe.

8. Dispositif selon l'une des revendications 1 à 7, dans lequel la région implantée verticale (AdVt) est dopée avec une concentration en dopants du deuxième type comprise entre 5*10¹⁵ at/cm³ et 10¹⁸ at/cm³, le substrat semiconducteur (SUB) étant dopé avec une concentration en dopants du premier type inférieure à 5*10¹⁵ at/cm³.

9. Dispositif selon l'une des revendications 1 à 8, dans lequel ladite grille de commande (CG) enterrée appartient à une tranchée (TR) s'étendant verticalement dans le substrat (SUB) et est superposée à une grille de sélection (SG) dans ladite tranchée (TR).

10. Procédé de fabrication d'un dispositif de mémoire non-volatile comportant des cellules mémoires (CEL1, CEL2), la fabrication de chaque cellule mémoire (CEL1, CEL2) comprenant :
- une formation (1100, 1200) d'une grille de commande (CG) verticalement enterrée dans un substrat semiconducteur (SUB) dopée d'un premier type de dopants ;
- une formation (800, 900 1000) d'une interface diélectrique (ITFD) apte à piéger des charges électriques recouvrant des flancs de la grille de commande (CG) en regard du substrat semiconducteur (SUB) ; et en outre
- une formation (500 ; 610, 620, 630, 640) d'une région implantée verticale (AdVt) d'un deuxième type de dopants opposé au premier type située le long desdits flancs de la grille de commande (CG) dans le substrat semiconducteur (SUB).

11. Procédé selon la revendication 10, dans lequel ladite fabrication de chaque cellule mémoires comprend :
- une formation (1300) d'une première région de conduction (D1) dopée du deuxième type de dopants, située dans le substrat au niveau d'une surface supérieure (FA) et d'un côté de la grille de commande (CG), et
- une formation (100) d'une deuxième région de conduction (S-NISO) dopée du deuxième type de dopants, située dans le substrat en profondeur au niveau du fond (FD) d'une tranchée (TR) contenant la grille de commande (CG) .

12. Procédé selon l'une des revendications 10 ou 11, comportant en outre des opérations d'écriture comprenant une génération de conditions d'effacement (ERTH) produisant une injection de porteurs chauds de charge d'un premier signe, dans l'interface diélectrique (ITFD), depuis ladite région implantée verticale (AdVt) comme source de porteurs de charge du premier signe.

13. Procédé selon la revendication 12, dans lequel les opérations d'écriture comprennent une génération des conditions d'effacement (ERHT) comprenant une polarisation de la grille de commande (CG) à un potentiel d'un deuxième signe, et une polarisation de la région implantée verticale (AdVt) à un potentiel du premier signe.

14. Procédé selon la revendication 13 prise en combinaison avec la revendication 10, dans lequel les opérations d'écriture comprennent une génération de la polarisation de la région implantée verticale (AdVt) avec un potentiel du premier signe non-nul dans la première région de conduction (D1) et un potentiel de référence nul dans la deuxième région de conduction (S-NISO), ou avec un potentiel de premier signe non-nul dans la deuxième région de conduction (S-NISO) et un potentiel de référence nul dans la première région de conduction (D1).

15. Procédé selon l'une des revendications 12 à 14, dans lequel les opérations d'écriture comprennent en outre une génération de conditions de programmation (PRHT) produisant une injection de porteurs chauds de charge du deuxième signe, dans l'interface diélectrique (ITFD), depuis une région de canal (CNL) formée le long desdits flancs de la grille de commande (CG) dans le substrat semiconducteur (SUB) comme source de porteur de charge du deuxième signe.

16. Procédé selon la revendication 15, dans lequel les opérations d'écriture comprennent en outre une génération des conditions de programmation (PRHT) comprenant une polarisation de la grille de commande (CG) à un potentiel du deuxième signe.

17. Procédé selon l'une des revendications 10 à 16, dans lequel :
- ladite formation de la grille de commande et ladite formation de l'interface diélectrique comprennent une gravure (100) d'une tranchée s'enfonçant verticalement dans le substrat semiconducteur ; et
- ladite formation de la région implantée verticale du deuxième type de dopants comprend, avant les formations (800, 900, 1000, 1100) des matériaux respectifs de l'interface diélectrique et de la grille de commande dans la tranchée :
-- une formation (620) d'un corps sacrificiel dopé du deuxième type de dopants remplissant la tranchée ;
-- une diffusion (630) des dopants du corps sacrificiel dans le substrat semiconducteur le long des flancs de la tranchée ;
-- un retrait (640) du corps sacrificiel de la tranchée.

18. Procédé selon l'une des revendications 10 à 17, dans lequel la région implantée verticale (AdVt) est dopée avec une concentration en dopants du deuxième type comprise entre 5*10¹⁵ at/cm³ et 10¹⁸ at/cm³, le substrat semiconducteur (SUB) étant dopé avec une concentration en dopants du premier type inférieure à 5*10¹⁵ at/cm³.

19. Procédé selon l'une des revendications 10 à 18, dans lequel la fabrication de chaque cellule mémoire (CEL1, CEL2) comprend en outre :
- une formation (200, 300, 400) d'une grille de sélection (SG) dans une tranchée (TR) s'étendant verticalement dans le substrat semiconducteur (SUB) ;
ladite formations (1100, 1200) de la grille de commande (CG) étant faite dans ladite tranchée (TR) par-dessus la grille de sélection (SG).
